(19) Europäisches Patentamt
European Patent Office
Office européen des brevets

(11) **EP 3 447 510 A1**

(12) **EUROPÄISCHE PATENTANMELDUNG**

(43) Veröffentlichungstag:
   **27.02.2019   Patentblatt 2019/09**

(51) Int Cl.:
   **G01R 31/36** (2019.01)   **H01M 10/48** (2006.01)

(21) Anmeldenummer: **17187421.7**

(22) Anmeldetag: **23.08.2017**

(84) Benannte Vertragsstaaten:
   **AL AT BE BG CH CY CZ DE DK EE ES FI FR GB GR HR HU IE IS IT LI LT LU LV MC MK MT NL NO PL PT RO RS SE SI SK SM TR**
   Benannte Erstreckungsstaaten:
   **BA ME**
   Benannte Validierungsstaaten:
   **MA MD**

(71) Anmelder: **HILTI Aktiengesellschaft**
   **9494 Schaan (LI)**

(72) Erfinder:
   • **Hauser, Klaus**
      **86830 Schwabmünchen (DE)**
   • **Koscheck, David**
      **81735 München (DE)**
   • **Mayer, Stefan**
      **85221 Dachau (DE)**

(74) Vertreter: **Hilti Aktiengesellschaft**
   **Corporate Intellectual Property**
   **Feldkircherstrasse 100**
   **Postfach 333**
   **9494 Schaan (LI)**

(54) **ERMITTELN DER LADUNG IN EINEM AKKU MIT EINER WERKZEUGMASCHINE**

(57)   Verfahren zum Ermitteln eines Ladungswertes für ein System enthalten eine Werkzeugmaschine (1) sowie wenigstens einen Akkumulator (12), wobei der wenigstens eine Akkumulator zur Versorgung der Werkzeugmaschine mit elektrischer Energie dient.

Das Verfahren enthält die Verfahrensschritte
- Erfassen eines ersten Ladungswertes einer elektrischen Ladung des wenigstens einen Akkumulators zu einem ersten Zeitpunkt;
- Erfassen eines Stromwertes eines elektrischen Stroms, welcher von dem wenigstens einen Akkumulator zu der Werkzeugmaschine für die Versorgung der elektrischen Verbraucher in der Werkzeugmaschine fließt, zwischen einem zweiten und dritten Zeitpunkt ($t_2$, $t_3$);
- Ermitteln eines zweiten Ladungswertes anhand des erfassten Stromwertes zwischen einem zweiten und dritten Zeitpunkt; und
- Subtrahieren des zweiten Ladungswerts von dem ersten Ladungswert zum Ermitteln eines dritten Ladungswertes zu dem zweiten Zeitpunkt.

Akkumulator, Werkzeugmaschine sowie System enthaltend wenigstens einen Akkumulator sowie eine Werkzeugmaschine zur Durchführung des Verfahrens.

Fig. 1

EP 3 447 510 A1

**Beschreibung**

Die vorliegende Erfindung betrifft ein Verfahren zum Ermitteln eines Ladungswertes für ein System enthaltend eine Werkzeugmaschine sowie wenigstens einen Akkumulator, wobei der wenigstens eine Akkumulator zur Versorgung der Werkzeugmaschine mit elektrischer Energie dient.

Des Weiteren betrifft die Erfindung einen Akkumulator sowie eine Werkzeugmaschine zur Durchführung des Verfahrens. Darüber hinaus betrifft die vorliegende Erfindung ein System enthaltend wenigstens einen Akkumulator sowie eine Werkzeugmaschine zur Durchführung des Verfahrens.

Kabellose Werkzeugmaschine können zur Strom- bzw. Energieversorgung mit einem Akkumulator, auch Akku genannt, betrieben werden. Bei der kabellosen Werkzeugmaschine kann es sich beispielsweise um einen Akku-Schrauber, einen Bohrhammer oder dergleichen handeln.

Akkumulatoren enthalten für gewöhnlich eine Anzahl an Speicherzellen bzw. Energiespeicherzellen für elektrische Energie. Zur Kontrolle eines Lade- bzw. Entladevorgangs der Speicherzellen, bei dem die Speicherzellen entweder mit einer elektrischen Energie geladen oder die elektrische Energie aus den Speicherzellen genommen wird, verfügt ein moderner Akkumulator über eine Steuerungselektronik zur Regelung und Steuerung verschiedener Vorgänge in dem Akkumulator. Die Speicherzellen werden auch als Akku-Zellen bezeichnet.

Akkumulatoren gemäß dem Stand der Technik verfügen häufig aus Kostengründen nicht über eine Vorrichtung, um einem Anwender einer akkubetriebenen Werkzeugmaschine verlässlich den aktuellen Ladungszustand bzw. die noch zur Verfügung stehende Energiemenge des Akkumulators zu jedem Zeitpunkt anzuzeigen.

Eine möglichst genaue Erfassung des aktuellen Ladungszustands bzw. der noch gespeicherten Energiebzw. Ladungsmenge in dem Akkumulator ermöglicht es jedoch dem Anwender besser abzuschätzen, ob geplante Tätigkeiten bzw. Arbeiten mit der akkubetriebenen Werkzeugmaschine mit der Restladung des Akkumulators noch vollständig abgeschlossen werden können oder ob der Akkumulator zunächst aufgeladen werden muss.

Gemäß dem Stand der Technik ist es bereits möglich, mit Hilfe der Messung der Leerlaufspannung des Akkumulators den aktuellen bzw. tatsächlichen Ladezustand (d.h. Ladungsmenge bzw. Energiemenge) ermitteln zu können. Diese Messung ist jedoch nur in einem Ruhezustand der Werkzeugmaschine möglich, wenn kein elektrischer Strom von dem Akkumulator zu der Werkzeugmaschine fließt.

Aufgabe der vorliegenden Erfindung ist es daher, einen Verfahren zur Verfügung zu stellen zum Ermitteln eines Ladungswertes für ein System enthalten eine Werkzeugmaschine sowie wenigstens einen Akkumulator, wobei der wenigstens eine Akkumulator zur Versorgung der Werkzeugmaschine mit elektrischer Energie dient.

Des Weiteren ist es auch Aufgabe der vorliegenden Erfindung einen Akkumulator, eine Werkzeugmaschine sowie ein System enthaltend wenigstens einen Akkumulator sowie eine Werkzeugmaschine zur Durchführung des Verfahrens bereitzustellen, mit denen das vorstehend genannte Problem gelöst werden kann.

Die Aufgabe wird gelöst durch den Gegenstand des unabhängigen Anspruchs 1, 2, 3 und 4.

Die Aufgabe wird insbesondere gelöst durch ein Verfahren zum Ermitteln eines Ladungswertes für ein System enthalten eine Werkzeugmaschine sowie wenigstens einen Akkumulator, wobei der wenigstens eine Akkumulator zur Versorgung der Werkzeugmaschine mit elektrischer Energie dient.

Erfindungsgemäß sind für das Verfahren die folgenden Schritte vorgesehen

- Erfassen eines ersten Ladungswertes einer elektrischen Ladung des wenigstens einen Akkumulators zu einem ersten Zeitpunkt;

- Erfassen eines Stromwertes eines elektrischen Stroms, welcher von dem wenigstens einen Akkumulator zu der Werkzeugmaschine für die Versorgung der elektrischen Verbraucher in der Werkzeugmaschine fließt, zwischen einem ersten und zweiten Zeitpunkt;

- Ermitteln eines zweiten Ladungswertes anhand des erfassten Stromwertes zwischen dem ersten und zweiten Zeitpunkt; und

- Subtrahieren des zweiten Ladungswerts von dem ersten Ladungswert zum Ermitteln eines dritten Ladungswertes zu dem zweiten Zeitpunkt.

Hierdurch bzw. insbesondere durch die Ermittlung des dritten Ladungswertes kann der aktuelle bzw. tatsächliche Ladezustand des Akkumulators auch während der Verwendung der akkubetriebenen Werkzeugmaschine, d.h. wenn elektrischer Strom von dem Akkumulator zur Werkzeugmaschine fließt und der Elektromotor der Werkzeugmaschine in Betrieb ist, zuverlässig ermittelt werden. Somit ist der Anwender der akkubetriebenen Werkzeugmaschine jederzeit in der Lage, die im Akkumulator noch gespeicherte Energie für bevorstehende Arbeiten genau einzuschätzen.

Es ist dabei gemäß einer vorteilhaften Ausführungsform möglich, dass der erste Ladungswert einer elektrischen Ladung des wenigstens einen Akkumulators auf einem nichtflüchtigen Speicher (Non-Volatile Memory (NVM)) gespeichert wird.

Der Zeitraum zwischen dem ersten und zweiten Zeitpunkt kann auch als erstes Zeitintervall bezeichnet werden. Der Zeitraum zwischen dem zweiten und dritten Zeitpunkt kann auch als zweites Zeitintervall bezeichnet werden.

Des Weiteren wird die Aufgabe gelöst durch einen Akkumulator mit einer Werkzeugmaschine verbindbar, welcher zur Durchführung des Verfahrens ausgestaltet ist. Der Akkumulator kann dabei eine Ladungsmessvorrichtung enthalten zum Erfassen eines ersten Ladungswertes einer elektrischen Ladung in dem Akkumulator.

Darüber hinaus wird die Aufgabe gelöst durch eine Werkzeugmaschine zur Durchführung des Verfahrens. Die Werkzeugmaschine kann dabei eine Strommessvorrichtung enthalten zum Erfassen eines Stromwertes eines elektrischen Stroms in der Werkzeugmaschine, welcher von dem wenigstens einen Akkumulator zu der Werkzeugmaschine für die Versorgung der elektrischen Verbraucher in der Werkzeugmaschine fließt. Ferner kann die Werkzeugmaschine einen Prozessor enthalten zum Ermitteln eines zweiten Ladungswertes anhand des erfassten Stromwertes zwischen einem ersten und zweiten Zeitpunkt.

Des Weiteren wird die Aufgabe gelöst durch ein System enthaltend wenigstens einen Akkumulator sowie eine Werkzeugmaschine zur Durchführung des Verfahrens.

Weitere Vorteile ergeben sich aus der folgenden Figurenbeschreibung. In den Figuren sind verschiedene Ausführungsbeispiele der vorliegenden Erfindung dargestellt. Die Figuren, die Beschreibung und die Ansprüche enthalten zahlreiche Merkmale in Kombination. Der Fachmann wird die Merkmale zweckmässigerweise auch einzeln betrachten und zu sinnvollen weiteren Kombinationen zusammenfassen.

Es zeigen:

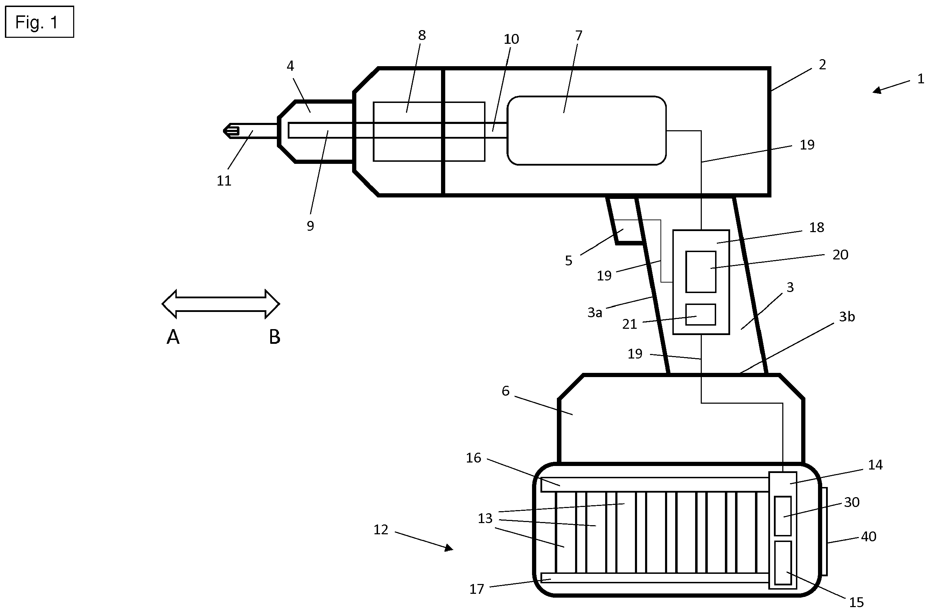

Fig. 1    eine Schnittansicht einer erfindungsgemäßen Werkzeugmaschine mit einem erfindungsgemäßen an der Werkzeugmaschine angeschlossenen Akkumulator.

**Ausführungsbeispiele:**

In Figuren 1 ist eine erfindungsgemäße Werkzeugmaschine 1 dargestellt. Die Werkzeugmaschine 1 ist beispielsweise in Form eines Akku-Schraubers ausgestaltet und enthält im Wesentlichen ein Gehäuse 2, ein Handgriff 3, eine Werkzeugaufnahme 4, einen Aktivierungsschalter 5 sowie ein Fussteil 6.

Im Inneren des Gehäuses 2 ist ein Elektromotor 7, ein Getriebe 8, eine Antriebswelle 9 und eine Abtriebswelle 10 positioniert. Der Elektromotor 7 enthält einen drehbaren Rotor sowie einen Stator und ist über die Abtriebswelle 10 mit dem Getriebe 8 verbunden. Weder der Rotor noch der Stator sind in der Figur dargestellt.

Das Getriebe 8 ist weiterhin über die Antriebswelle 9 mit der Werkzeugaufnahme 4 verbunden. Der Elektromotor 7 dient zum Erzeugen eines Drehmoments, welches über die Abtriebswelle 10, das Getriebe 8 und die Antriebswelle 9 auf die Werkzeugaufnahme 4 übertragen werden kann. Die Werkzeugaufnahme 4 ist an einem vorderen Ende 2a des Gehäuses 2 der Werkzeugmaschine 1 positioniert. Mit der Werkzeugaufnahme 4 kann ein Werkzeug 11, beispielsweise in Form eines Schraubendreherklinge (auch Bit genannt), aufgenommen und gehalten werden. Die Werkzeugaufnahme 4 überträgt das Drehmoment von der Antriebswelle 9 auf das als Bit ausgestaltete Werkzeug 11, um eine Schraube in einen Werkstoff (z.B. Holz) zu schrauben. Das Werkstoff und die Schraube sind in der Figur nicht dargestellt.

Am einem unteren Ende des Gehäuses 2 ist der Handgriff 3 befestigt. Der Handgriff 3 weist insbesondere eine Vorderseite 3a und ein unteres Ende 3b auf. An der Vorderseite 3a ist der Aktivierungsschalter 5 positioniert. Über den Aktivierungsschalter 5 kann ein Anwender der Werkzeugmaschine 1 den Elektromotor 7 und damit das Werkzeug 11 zum Drehen bringen. Des Weiteren ist an dem unteren Ende 3b des Handgriffs 3 das Fussteil 6 befestigt. An einem unteren Ende 6a des Fussteils 6 ist wiederum ein Akkumulator 12 (auch Akku genannt) lösbar positioniert.

Der Akkumulator 12 ist lösbar mit der Werkzeugmaschine 1 verbunden und dient zum Versorgen der Werkzeugmaschine 1 mit elektrischer Energie bzw. mit elektrischem Strom. Der Akkumulator 12 enthält hierzu im Wesentlichen in seinem Inneren eine Anzahl an Energiespeicherzellen 13 (auch Akku-Zellen genannt) sowie eine Steuerung 14. Die Energiespeicherzellen 13 und die Steuerung 14 sind miteinander verbunden. Mit Hilfe der Energiespeicherzellen 13 kann elektrische Energie bzw. eine elektrische Ladung gespeichert und einem Verbraucher zur Verfügung gestellt werden.

Die Steuerung 14 des Akkumulators 12 enthält wiederum eine Ladungsmessvorrichtung 15. Die Ladungsmessvorrichtung 15 dient zum Erfassen eines ersten Ladungswertes einer elektrischen Ladung, die in den Energiespeicherzellen 13 gespeichert ist. Der erste Ladungswert entspricht dabei der zur Verfügung stehenden elektrischen Ladung in den Energiespeicherzellen 13 zu einem bestimmten Zeitpunkt.

Die einzelnen Energiespeicherzellen 13 sind über eine obere und untere Zellenhalterung 16, 17 mechanisch und elektrisch mit der Steuerung 14 verbunden, sodass elektrische Energie bzw. elektrischer Strom von den einzelnen Energiespeicherzellen 13 zu der Steuerung 14 fließen kann. Die in der Steuerung 14 enthaltende Ladungsmessvorrichtung 15 misst in Zeitintervallen, d.h. im Abstand von bestimmten Zeitpunkten, die noch in den Energiespeicherzellen 13 gespeicherte elektrische Ladung. Die Werte der gemessenen elektrischen Ladung werden in einem nichtflüchtigen Speicher 30 gespeichert.

Im Inneren des Handgriffs 3 ist eine Steuerungsvorrichtung 18 für die Werkzeugmaschine 1 vorgesehen. Die Steuerungsvorrichtung 18 ist über entsprechende Leitungen 19 mit dem Elektromotor 7, dem Aktivierungsschalter 5 sowie der Steuerung 14 des Akkumulators 12 verbunden. Die Leitungen 19 dienen dabei zum Übertragen von Signalen und elektrischem Strom.

Durch ein Bewegen des Aktivierungsschalters 5 in Richtung B kann ein Signal von dem Aktivierungsschalter 5 an die Steuerungsvorrichtung 18 gesendet werden, wodurch die Steuerungsvorrichtung 18 wiederum ein Signal an die Steuerung 14 des Akkumulators 12 sendet. Durch das an die Steuerung 14 gesendete Signal wird elektrische Energie bzw. elektrischer Strom mit einem bestimmten Stromwert von den Energiespeicherzellen 13 zu den elektrischen Verbrauchern der Werkzeugmaschine 1 und insbesondere den Elektromotor 7 gesendet. Um ein Signal entsprechend der Wegstrecke des Aktivierungsschalters 5 in Richtung B an die Steuerungsvorrichtung 18 zu senden, enthält der Aktivierungsschalter 5 ein nicht gezeigtes Potentiometer, auch Poti genannt.

Wenn sich der Aktivierungsschalter 5 wieder in Richtung A bewegt, wird ein entsprechendes Signal mit Hilfe des Potentiometers an die Steuerungsvorrichtung 18 gesendet, sodass keine elektrische Ladung bzw. elektrischer Strom mehr von den Energiespeicherzellen 13 zu der Werkzeugmaschine 1 fließt.

Die Steuerungsvorrichtung 18 enthält des Weiteren eine Strommessvorrichtung 20 sowie einen Prozessor 21.

Die Strommessvorrichtung 20 dient zum Erfassen eines Stromwertes eines elektrischen Stroms, welcher von den Energiespeicherzellen 13 zu der Werkzeugmaschine 1 für die Versorgung der elektrischen Verbraucher, insbesondere Elektromotor 7, in der Werkzeugmaschine 1 fließt. Das Erfassen bzw. Messen des Stromwertes erfolgt dabei zwischen einem ersten Zeitpunkt $t_1$ und zweiten Zeitpunkt $t_2$ für eine bestimmte Zeitdauer bzw. für ein bestimmtes Zeitintervall.

Zur Durchführung des erfindungsgemäßen Verfahrens wird zunächst die aktuelle elektrische Ladung $Q(t_1)$ in den Energiespeicherzellen 13 zu einem bestimmten ersten Zeitpunkt $t_1$ erfasst. Die Erfassung bzw. die Messung der Ladung $Q(t_1)$ erfolgt dabei mittels der Ladungsmessvorrichtung 15 in dem Akkumulator 12. Der Wert der aktuellen elektrischen Ladung $Q(t_1)$ wird in dem Speicher 30 gespeichert. Es können dabei auch mehrere Werte der elektrischen Ladung systematisch in dem Speicher 30 gespeichert werden. Der Wert der aktuellen elektrischen Ladung $Q(t_1)$ wird über die Leitung 19 von der Steuerung 14 des Akkus 12 zu der Steuerungsvorrichtung 18 der Werkzeugmaschine 1 gesendet.

Wenn die Werkzeugmaschine 1 in Verwendung ist, d.h. mit Hilfe des Aktivierungsschalters 5 der Elektromotor 7 betreiben wird, fließt elektrischer Strom von den Energiespeicherzellen 13 über die Steuerung 14 des Akkumulators 12, die Leitung 19 und die Steuerungsvorrichtung 18 der Werkzeugmaschine 1 zu dem Elektromotor 7. Der nicht gezeigte Rotor des Elektromotors 7 kann durch den elektrischen Strom in Drehung versetzt werden, um damit ein Drehmoment für das Werkzeug 11 zu erzeugen.

Die Strommessvorrichtung 20 der Steuerungsvorrichtung 18 erfasst die Menge des elektrischen Stroms, der in einem ersten Zeitintervall, d.h. zwischen einem ersten Zeitpunkt $t_1$ und zweiten Zeitpunkt $t_2$ von den Energiespeicherzellen 13 durch die Steuerung 14 und schließlich zu dem Elektromotor 7 fließt. Mit Hilfe der Gleichungen:

$$Q = I \times t$$

$$Q(t_3) = Q(t_1) - \int_{t_1}^{t_2} I(t)\, dt$$

wobei

$Q(t_3)$ = gesamte verbleibende elektrische Ladung in den Energiespeicherzellen 13 zum dritten Zeitpunkt;

$Q(t_1)$ = aktuelle elektrische Ladung in den Energiespeicherzellen 13 zum ersten Zeitpunkt;

$I$ = Stromstärke in Amper (A bzw. mA)

$t$ = Zeit

$t_1$ bis $t_2$ = Zeitintervall zwischen einem ersten und zweiten Zeitpunkt

ist, wird durch den Prozessor 21 die elektrische Ladung als Integral des elektrischen Stroms, der zur Versorgung der elektrischen Verbraucher in der Werkzeugmaschine 1 fließt, über den Zeitintervall, d.h. zwischen dem ersten Zeitpunkt $t_1$ und den zweiten Zeitpunkt $t_2$, ermittelt.

Zum Ermitteln der elektrischen Ladung dient die Tatsache, dass die Ladung, die in oder durch einen Körper geflossen ist, das Integral des elektrischen Stromes über der Zeit darstellt.

Der Wert der in der Werkzeugmaschine 1 ermittelten elektrischen Ladung wird über die Leitungen 19 von der Steuerungsvorrichtung 18 zu der Steuerung 14 des Akkumulators 12 gesendet. In der Steuerung 14 des Akkumulators 12 wird der Wert der ermitteln Ladung (d. h. das Integral des geflossenen elektrischen Stromes über der Zeit) von dem erfassten Ladung $Q(t_1)$ abgezogen (subtrahiert), wodurch die eigentlich in den Energiespeicherzellen 13 noch gespeicherte elektrische Ladung $Q(t_3)$ zum Zeitpunkt $t_3$ ermittelt ist.

An einer Anzeigevorrichtung 40 an dem Akkumulator 12 kann die ermittelte aktuell noch verfügbare elektrische Ladung $Q(t_3)$ zum Zeitpunkt $t_3$ angezeigt werden. Der Anwender der Werkzeugmaschine 1 wird somit informiert wieviel elektrische Energie tatsächlich noch mit dem Akkumulator 12 zur Verfügung steht.

Es ist gemäß einer weiteren (nicht in den Figuren gezeigten) Ausführungsform auch möglich, dass die Anzeigevorrichtung 40 zur Anzeige der ermittelten aktuell noch in den Energiespeicherzellen 13 verfügbaren

elektrischen Ladung $Q(t_3)$ zum Zeitpunkt $t_3$ an der Werkzeugmaschine 1 positioniert ist.

Darüber hinaus ist es gemäß einer weiteren (nicht in den Figuren gezeigten) Ausführungsform auch möglich, dass die Anzeige der ermittelten aktuell noch in den Energiespeicherzellen 13 verfügbaren elektrischen Ladung $Q(t_3)$ zum Zeitpunkt $t_3$ mittels einer drahtlosen Verbindung zu einem externen Anzeigegerät gesendet wird. Bei dem externen Anzeigegerät kann es sich beispielsweise um eine Brille für Augmented Reality, ein Smartphone oder dergleichen handeln.

Des Weiteren ist es auch gemäß dem vorstehend beschriebenen Verfahren möglich, dass die in der Werkzeugmaschine 1 ermittelte Ladung das Integral des elektrischen Stroms ist, der während eines Applikation, d.h. von Beginn bis zum Ende einer Applikation, verbraucht wird. Mit Applikation ist dabei ein tatsächlicher Arbeitsvorgang mit einer entsprechenden Werkzeugmaschine 1 gemeint, wie z.B. das Bohren eines Lochs, das Einschrauben einer Schraube, das Sägen einer bestimmten Wegstrecke eines Werkstoffs oder dergleichen. Durch das Ermitteln der elektrischen Ladung, die für eine bestimmte Applikation bzw. einen bestimmten Arbeitsvorgang benötigt wird, kann die Anzahl an Applikationen ermittelt und angezeigt werden, die noch mit der tatsächlich vorhandenen elektrischen Ladung $Q(t_3)$ in den Energiespeicherzellen 13 ausgeführt werden können.

## Patentansprüche

1. Verfahren zum Ermitteln eines Ladungswertes für ein System enthaltend eine Werkzeugmaschine (1) sowie wenigstens einen Akkumulator (12), wobei der wenigstens eine Akkumulator (12) zur Versorgung der Werkzeugmaschine (1) mit elektrischer Energie dient,

   **gekennzeichnet durch** die folgenden Verfahrensschritte

   - Erfassen eines ersten Ladungswertes einer elektrischen Ladung des wenigstens einen Akkumulators (12) zu einem ersten Zeitpunkt $(t_1)$;
   - Erfassen eines Stromwertes eines elektrischen Stroms, welcher von dem wenigstens einen Akkumulator (12) zu der Werkzeugmaschine (1) für die Versorgung der elektrischen Verbraucher (7) in der Werkzeugmaschine (1) fließt, zwischen einem ersten und zweiten Zeitpunkt $(t_1, t_2)$;
   - Ermitteln eines zweiten Ladungswertes anhand des erfassten Stromwertes zwischen dem ersten und zweiten Zeitpunkt $(t_1, t_2)$; und
   - Subtrahieren des zweiten Ladungswerts von dem ersten Ladungswert zum Ermitteln eines dritten Ladungswertes zu dem zweiten Zeitpunkt $(t_2)$.

2. Akkumulator (12) mit einer Werkzeugmaschine (1) verbindbar zur Durchführung des Verfahrens nach Anspruch 1,
   **gekennzeichnet durch** eine Ladungsmessvorrichtung (15) zum Erfassen eines ersten Ladungswertes einer elektrischen Ladung in dem Akkumulator (12).

3. Werkzeugmaschine (1) mit einem Akkumulator (12) verbindbar zur Durchführung des Verfahrens nach Anspruch 1,
   **gekennzeichnet durch** eine Strommessvorrichtung (20) zum Erfassen eines Stromwertes eines elektrischen Stroms in der Werkzeugmaschine (1), welcher von dem wenigstens einen Akkumulator (12) zu der Werkzeugmaschine (1) für die Versorgung der elektrischen Verbraucher (7) in der Werkzeugmaschine (1) fließt, sowie einen Prozessor (21) zum Ermitteln eines zweiten Ladungswertes anhand des erfassten Stromwertes zwischen einem ersten und zweiten Zeitpunkt $(t_1, t_2)$.

4. System enthaltend wenigstens einen Akkumulator (12) sowie eine Werkzeugmaschine (1) zur Durchführung des Verfahrens nach Anspruch 1.

Fig. 1

**EP 3 447 510 A1**

Europäisches Patentamt
European Patent Office
Office européen des brevets

# EUROPÄISCHER RECHERCHENBERICHT

Nummer der Anmeldung

EP 17 18 7421

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | EP 2 685 270 A2 (MAKITA CORP [JP]) 15. Januar 2014 (2014-01-15) * Absatz [0033] - Absatz [0124]; Abbildungen 2,3,5 * ----- | 1-4 | INV. G01R31/36 ADD. H01M10/48 |
| X | JP 2007 139549 A (MATSUSHITA ELECTRIC WORKS LTD) 7. Juni 2007 (2007-06-07) * Absatz [0039] - Absatz [0045]; Abbildungen 1-6,9 * * Absätze [0051], [0054] - Absätze [0065], [0073] * ----- | 1-4 | |
| X | US 2008/077338 A1 (WONG SHIH-FANG [TW] ET AL) 27. März 2008 (2008-03-27) * Absatz [0005] - Absatz [0009]; Abbildungen 1,2,4 * * Absatz [0020] - Absatz [0035] * ----- | 1-4 | |
| X | JP 2001 008372 A (JAPAN STORAGE BATTERY CO LTD) 12. Januar 2001 (2001-01-12) * Absatz [0002] - Absätze [0006], [0038], [0040]; Abbildungen 1,4-7 * ----- | 1-4 | |
| A | US 2014/342193 A1 (MULL BENJAMIN C [US] ET AL) 20. November 2014 (2014-11-20) * Absätze [0018], [0060]; Abbildung 6 * ----- | 1-4 | RECHERCHIERTE SACHGEBIETE (IPC) G01R H01M |

Der vorliegende Recherchenbericht wurde für alle Patentansprüche erstellt

| Recherchenort | Abschlußdatum der Recherche | Prüfer |
|---|---|---|
| München | 25. Januar 2018 | Hof, Klaus-Dieter |

EPO FORM 1503 03.82 (P04C03)

**ANHANG ZUM EUROPÄISCHEN RECHERCHENBERICHT**
**ÜBER DIE EUROPÄISCHE PATENTANMELDUNG NR.**

EP 17 18 7421

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

25-01-2018

| Im Recherchenbericht angeführtes Patentdokument | | Datum der Veröffentlichung | Mitglied(er) der Patentfamilie | | | Datum der Veröffentlichung |
|---|---|---|---|---|---|---|
| EP 2685270 | A2 | 15-01-2014 | CN | 103543406 | A | 29-01-2014 |
| | | | EP | 2685270 | A2 | 15-01-2014 |
| | | | JP | 6207127 | B2 | 04-10-2017 |
| | | | JP | 2014020798 | A | 03-02-2014 |
| | | | US | 2014019074 | A1 | 16-01-2014 |
| | | | US | 2017160346 | A1 | 08-06-2017 |
| JP 2007139549 | A | 07-06-2007 | JP | 4678284 | B2 | 27-04-2011 |
| | | | JP | 2007139549 | A | 07-06-2007 |
| US 2008077338 | A1 | 27-03-2008 | CN | 101153894 | A | 02-04-2008 |
| | | | US | 2008077338 | A1 | 27-03-2008 |
| JP 2001008372 | A | 12-01-2001 | KEINE | | | |
| US 2014342193 | A1 | 20-11-2014 | KEINE | | | |

Für nähere Einzelheiten zu diesem Anhang : siehe Amtsblatt des Europäischen Patentamts, Nr.12/82

EPO FORM P0461